(19) Europäisches Patentamt / European Patent Office / Office européen des brevets

(11) **EP 3 788 564 B1**

(12) **EUROPEAN PATENT SPECIFICATION**

(45) Date of publication and mention of the grant of the patent:
**30.10.2024  Bulletin 2024/44**

(51) International Patent Classification (IPC):
**G06N 10/70** (2022.01)    **G06N 10/20** (2022.01)
**G06N 5/01** (2023.01)    G06N 5/022 (2023.01)

(21) Application number: **19732200.1**

(22) Date of filing: **05.06.2019**

(52) Cooperative Patent Classification (CPC):
**G06N 5/01; G06N 10/20; G06N 10/70;** G06N 5/022

(86) International application number:
**PCT/US2019/035595**

(87) International publication number:
**WO 2019/236712 (12.12.2019 Gazette 2019/50)**

(54) **LAYOUTS FOR FAULT-TOLERANT QUANTUM COMPUTERS**

LAYOUTS FÜR FEHLERTOLERANTE QUANTENCOMPUTER

AGENCEMENTS POUR ORDINATEURS QUANTIQUES INSENSIBLES AUX DÉFAILLANCES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **06.06.2018   US 201862681540 P**

(43) Date of publication of application:
**10.03.2021   Bulletin 2021/10**

(60) Divisional application:
**24201171.6**

(73) Proprietor: **Microsoft Technology Licensing, LLC Redmond, WA 98052-6399 (US)**

(72) Inventors:
• **KLIUCHNIKOV, Vadym**
  **Redmond, Washington 98052 (US)**
• **DELFOSSE, Nicolas**
  **Redmond, Washington 98052 (US)**
• **VASCHILLO, Alexander**
  **Redmond, Washington 98052 (US)**

(74) Representative: **Page White Farrer**
**Bedford House**
**21a John Street**
**London WC1N 2BF (GB)**

(56) References cited:
EP-A1- 3 300 004         EP-A1- 3 300 004
WO-A1-2015/188025       WO-A1-2016/081788

WO-A1-2016/081788        WO-A1-2016/164325
WO-A1-2017/053986        WO-A1-2017/053986
WO-A1-2017/127923        US-A1- 2019 044 543
US-A1- 2019 044 543      US-A1- 2019 080 254
US-A1- 2019 080 254

• **ALEXANDRU PALER ET AL: "Synthesis of Arbitrary Quantum Circuits to Topological Assembly", ARXIV.ORG, CORNELL UNIVERSITY LIBRARY, 201 OLIN LIBRARY CORNELL UNIVERSITY ITHACA, NY 14853, 28 April 2016 (2016-04-28), XP080964579, DOI: 10.1038/SREP30600**
• **CRAIG GIDNEY: "Halving the cost of quantum addition", ARXIV.ORG, CORNELL UNIVERSITY LIBRARY, 201 OLIN LIBRARY CORNELL UNIVERSITY ITHACA, NY 14853, 19 September 2017 (2017-09-19), XP080817542**
• **GUANG HAO LOW ET AL: "Trading T-gates for dirty qubits in state preparation and unitary synthesis", ARXIV.ORG, CORNELL UNIVERSITY LIBRARY, 201 OLIN LIBRARY CORNELL UNIVERSITY ITHACA, NY 14853, 3 December 2018 (2018-12-03), XP080988454**
• **MICHAEL BEVERLAND ET AL: "Lower bounds on the non-Clifford resources for quantum computations", ARXIV.ORG, CORNELL UNIVERSITY LIBRARY, 201 OLIN LIBRARY CORNELL UNIVERSITY ITHACA, NY 14853, 1 April 2019 (2019-04-01), XP081163613**

EP 3 788 564 B1

- CHRISTOPHER CHAMBERLAND ET AL: "Fault-Tolerant Quantum Computing in the Pauli or Clifford Frame with Slow Error Diagnostics", ARXIV.ORG, CORNELL UNIVERSITY LIBRARY, 201 OLIN LIBRARY CORNELL UNIVERSITY ITHACA, NY 14853, 21 April 2017 (2017-04-21), XP081301640, DOI: 10.22331/Q-2018-01-04-43
- RODNEY VAN METER ET AL: "Local and Distributed Quantum Computation", ARXIV.ORG, CORNELL UNIVERSITY LIBRARY, 201 OLIN LIBRARY CORNELL UNIVERSITY ITHACA, NY 14853, 23 May 2016 (2016-05-23), XP080702890
- DANIEL K L OI ET AL: "Scalable Error Correction in Distributed Ion Trap Computers", ARXIV.ORG, CORNELL UNIVERSITY LIBRARY, 201 OLIN LIBRARY CORNELL UNIVERSITY ITHACA, NY 14853, 27 June 2006 (2006-06-27), XP080243148, DOI: 10.1103/PHYSREVA.74.052313
- KRISTIAAN DE GREVE ET AL: "Ultrafast optical control of individual quantum dot spin qubits", REPORTS ON PROGRESS IN PHYSICS, INSTITUTE OF PHYSICS PUBLISHING, BRISTOL, GB, vol. 76, no. 9, 4 September 2013 (2013-09-04), pages 92501, XP020249535, ISSN: 0034-4885, [retrieved on 20130904], DOI: 10.1088/0034-4885/76/9/092501
- ALEXANDRU PALER ET AL: "Fault-tolerant, high-level quantum circuits: form, compilation and description", QUANTUM SCIENCE AND TECHNOLOGY, vol. 2, no. 2, 12 April 2017 (2017-04-12), pages 1 - 18, XP055476820, DOI: 10.1088/2058-9565/aa66eb
- AUSTIN G. FOWLER ET AL: "Surface codes: Towards practical large-scale quantum computation", PHYSICAL REVIEW A (ATOMIC, MOLECULAR, AND OPTICAL PHYSICS), vol. 86, no. 3, 26 October 2012 (2012-10-26), USA, XP055332246, ISSN: 1050-2947, DOI: 10.1103/PhysRevA.86.032324
- VADYM KLIUCHNIKOV ET AL: "Fast and efficient exact synthesis of single qubit unitaries generated by Clifford and T gates", 27 February 2013 (2013-02-27), XP055480807, Retrieved from the Internet <URL:https://arxiv.org/pdf/1206.5236.pdf> [retrieved on 20180604]
- CHRISTOPHER CHAMBERLAND ET AL: "Fault-Tolerant Quantum Computing in the Pauli or Clifford Frame with Slow Error Diagnostics", ARXIV.ORG, CORNELL UNIVERSITY LIBRARY, 201 OLIN LIBRARY CORNELL UNIVERSITY ITHACA, NY 14853, 21 April 2017 (2017-04-21), XP081301640, DOI: 10.22331/Q-2018-01-04-43
- RODNEY VAN METER ET AL: "Local and Distributed Quantum Computation", ARXIV.ORG, CORNELL UNIVERSITY LIBRARY, 201 OLIN LIBRARY CORNELL UNIVERSITY ITHACA, NY 14853, 23 May 2016 (2016-05-23), XP080702890
- DANIEL K L OI ET AL: "Scalable Error Correction in Distributed Ion Trap Computers", ARXIV.ORG, CORNELL UNIVERSITY LIBRARY, 201 OLIN LIBRARY CORNELL UNIVERSITY ITHACA, NY 14853, 27 June 2006 (2006-06-27), XP080243148, DOI: 10.1103/PHYSREVA.74.052313
- KRISTIAAN DE GREVE ET AL: "Ultrafast optical control of individual quantum dot spin qubits", REPORTS ON PROGRESS IN PHYSICS, INSTITUTE OF PHYSICS PUBLISHING, BRISTOL, GB, vol. 76, no. 9, 4 September 2013 (2013-09-04), pages 92501, XP020249535, ISSN: 0034-4885, [retrieved on 20130904], DOI: 10.1088/0034-4885/76/9/092501
- ALEXANDRU PALER ET AL: "Fault-tolerant, high-level quantum circuits: form, compilation and description", QUANTUM SCIENCE AND TECHNOLOGY, vol. 2, no. 2, 12 April 2017 (2017-04-12), pages 1 - 18, XP055476820, DOI: 10.1088/2058-9565/aa66eb
- AUSTIN G. FOWLER ET AL: "Surface codes: Towards practical large-scale quantum computation", PHYSICAL REVIEW A (ATOMIC, MOLECULAR, AND OPTICAL PHYSICS), vol. 86, no. 3, 26 October 2012 (2012-10-26), USA, XP055332246, ISSN: 1050-2947, DOI: 10.1103/PhysRevA.86.032324
- VADYM KLIUCHNIKOV ET AL: "Fast and efficient exact synthesis of single qubit unitaries generated by Clifford and T gates", 27 February 2013 (2013-02-27), XP055480807, Retrieved from the Internet <URL:https://arxiv.org/pdf/1206.5236.pdf> [retrieved on 20180604]

**Description**

## CROSS-REFERENCE TO RELATED APPLICATIONS

This application claims the benefit of U.S. Provisional Application No. 62/681,540, entitled "LAYOUTS FOR FAULT-TOLERANT QUANTUM COMPUTERS" and filed on June 6, 2018.

PRIOR ART

CHRISTOPHER CHAMBERLAND ET AL: "Fault-Tolerant Quantum Computing in the Pauli or Clifford Frame with Slow Error Diagnostics",ARXIV.ORG, CORNELL UNIVERSITY LIBRARY, 201 OLIN LIBRARY CORNELL UNIVERSITY ITHACA, NY 14853, 21 April 2017 (2017-04-21), DOI: 10.22331/Q-2018-01-04-43 teaches fault-tolerantt quantum computation techniques in the context of slow error diagnostics.

RODNEY VAN METER ET AL: "Local and Distributed Quantum Computation",ARXIV.ORG, CORNELL UNIVERSITY LIBRARY, 201 OLIN LIBRARY CORNELL UNIVERSITY ITHACA, NY 14853, 23 May 2016 (2016-05-23) teaches techniques related to the scalability of quantum error correction.

ALEXANDRU PALER ET AL: "Fault-tolerant, high-level quantum circuits: form, compilation and description",QUANTUM SCIENCE AND TECHNOLOGY, vol. 2, no. 2, 12 April 2017 (2017-04-12), pages 1-18, DOI: 10.1088/2058-9565/aa66eb teaches compilation techniques in the context of fault-tolerant quantum computations.

SUMMARY

Disclosed herein are example layouts and layout generation techniques for fault-tolerant quantum computers. The invention is defined by the appended independent claims. The appended dependent claims define preferred embodiments.

## BRIEF DESCRIPTION OF THE DRAWINGS

Figure 1 is a schematic block diagram that represents the circuit realizing a CNOT gate between the top qubit and the bottom qubit.

Figure 2 is a schematic block diagram showing an example of providing a multi-target CNOT gate by measurement.

Figure 3 is a schematic block diagram illustrating a modified version of Figure 2 after moving the purple measurement $M_{Z_1 Z_4}$ to the left to parallelize the final red block between the ancillas and the targets.

Figure 4 is a schematic block diagram illustrating further modifying the initial measurements to parallelize the purple block between the control qubit and the ancillas (The effect of this parallelization appears only when more than two targets are present).

Figure 5 is a schematic block diagram of a further general circuit.

Figure 6 is a schematic block diagram of an example circuit that propagates a Pauli operator $X_C$.

Figure 7 is a block diagram representing the planar layout for the multi-target CNOT gate of Figure 6.

Figure 8 is a flow chart showing a general method.

Figure 9 is a flow chart showing a further general method.

Figure 10 illustrates a generalized example of a suitable classical computing environment.

Figure 11 shows an example of a possible network topology (e.g., a client-server network).

Figure 12 shows another example of a possible network topology (e.g., a distributed computing environment).

Figure 13 shows an exemplary system.

## DETAILED DESCRIPTION

1. GENERAL CONSIDERATIONS

As used in this application, the singular forms "a," "an," and "the" include the plural forms unless the context clearly dictates otherwise. Additionally, the term "includes" means "comprises." Further, the term "coupled" does not exclude the presence of intermediate elements between the coupled items. Further, as used herein, the term "and/or" means any one item or combination of any items in the phrase.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatus can be used in conjunction with other systems, methods, and apparatus. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one of ordinary skill in the art.

## 2. QUANTUM COMPUTING PRELIMINARIES AND NOTATION

Let $I$, $X$, $Y$ and $Z$ denote single qubit Pauli matrices. All single qubit Pauli matrices are Hermitian matrices. Square of every Pauli matrix is equal to $I$. A multiple qubit Pauli matrix is a tensor product (denoted as $\otimes$) of single qubit Pauli matrices. Notation $X_k$, $Y_k$, $Z_k$ refers to a multiple qubit Pauli matrix with $X$, $Y$ and $Z$ on qubit $k$ and $I$ on all other qubits. For example $X_2$ as 3 qubit Pauli matrix refers to the matrix:

$$I \otimes X \otimes I.$$

Multiple qubit Pauli matrices are also Hermitian and their square is the identity matrix. Below, the multiple qubit Pauli matrix will simply be called a Pauli matrix. $I$ is used for the identity matrix on any number of qubits. The dimension of $I$ will be clear from the context.

The notation $P|_k$ is used for the $k$-th component of the multi-qubit Pauli matrix. For example, for $P = X_a Y_b Z_c$, $P|_a = X$, $P|_b = Y$ and $P|_c = Z$.

For any square matrix $A$, $\mathrm{Tr}(A)$ is the sum of the diagonal elements of $A$. For arbitrary square matrices $A$, $B$ it is the case that $\mathrm{Tr}(AB) = \mathrm{Tr}(BA)$. In addition, $\mathrm{Tr}(A \otimes B) = \mathrm{Tr}(A) \cdot \mathrm{Tr}(B)$.

Orthogonal projector is a Hermitian matrix $C$ with property $C^2 = C$. $\mathrm{Tr}(C)$ is equal to the dimension of the subspace that $C$ projects onto.

Matrices $A$ and $B$ commute if $AB = BA$. Matrices $A$ and $B$ anti-commute if $AB = -BA$. Any two Pauli matrices either commute or anti-commute.

Plus state |+⟩ is $(|0\rangle + |1\rangle)/\sqrt{2}$.

$H_k$ is the Hadamard gate on qubit $k$. It is equal to $(X_k + Z_k)/\sqrt{2}$.

One-qubit Clifford gates are $H = (X + Z)/\sqrt{2},\ S = (I - Z)/\sqrt{2}$, products $HP$, $SP$, $HSP$, $SHP$, $HSHP$ where $P$ is $I$, $X$, $Y$, $Z$. One-qubit Clifford gates also include Pauli matrix $X$, $Y$, $Z$.

$CZ_{ij}$ is Controlled-Z gate on qubits $i$ and $j$. It is equal to $(I + Z_i + Z_j - Z_i Z_j)$.

Hermitian matrix $M$ stabilizes state $|\psi\rangle$ if the state $|\psi\rangle$ is +1 eigenvector of $M$. In other words, $M|\psi\rangle = |\psi\rangle$.

$n$-qubit cat state is the state $(|0\rangle^{\otimes n} + |1\rangle^{\otimes n})/\sqrt{2}$ also known as GHZ state.

Let $U$ be some unitary and let $Q = UPU^\dagger$, it will be said that $U$ maps $P$ to $Q$.

## 3. QUANTUM CIRCUIT LAYOUT PROBLEM

In this section, example embodiments of algorithms that solve special cases of the following problem are disclosed:

**Problem 3.1** (Layout problem for a graph). *Let $(V, E)$ be a graph and $V_{rot}$ be a subset of V. Vertexes are qubits. Consider quantum computation that uses one and two qubits Clifford operations, single qubit rotations* $\exp(i\phi Z)$ *and single qubit measurements. Perform a quantum computation that produces the same measurement outcomes using:*

- *one qubits measurements and one qubit Clifford unitaries,*
- *either (A) controlled-Z gates or (B) two qubit measurements on qubits connected by an edge*
- *single qubit rotations* $\exp(i\phi Z)$ *can only be performed on subset $V_{rot}$*

Using two (e.g., only two) qubit measurements on every edge is more restrictive. Any two qubit measurement can always be performed using two Controlled-Z gates, one measurement, and a single qubit Clifford gate. However, it is not possible to perform a Controlled-Z gate on two qubits by only measuring these two qubits. Restricting the qubits on which single qubit rotations can be performed reflects the fact that performing these rotations on a fault-tolerant quantum computer typically uses resource states that are usually produced in a dedicated part of the computer. Subset $V_{rot}$ represents qubits to which it is easy to deliver resource states needed to implement the rotations.

The above problem can also be reduced to the case where $V_{rot}$ comprises one element r and $(V, E)$ is a tree with the root $r$. Indeed, for any graph $(V, E)$ one can compute a spanning tree with root $r$. First, the solution for this case is described.

The first part of an example solution is to transform quantum computation to a canonical from. Here, the notation $M(a, P) = (I + aP)/2$ is used for the measurement of any multiple qubit Pauli operator P with outcome $a = \pm 1$. Suppose one has n qubit quantum computation described as:

$$(1) \qquad C_2 M(a, Z_{i(2)}) C_1 \exp(i\phi Z_{i(1)}) C_0 |0\rangle^{\otimes n}$$

where $C_k$ are some Clifford operators. Recall that for any Clifford operator $C$ and Pauli matrix $P$, product $CPC^\dagger$ is a Pauli matrix. Recall also that exponents and measurement have the following property:

$$(2) \qquad UM(a, P)U^\dagger = M(a, UPU^\dagger), U\exp(i\phi P)U^\dagger = \exp(i\phi UPU^\dagger)$$

One can rewrite quantum computation (1) as:

$$C_2 C_1 C_0 \big( (C_1 C_0)^\dagger M(a, Z_{i(2)}) C_1 C_0 \big) \Big( C_0^\dagger \exp(i\phi Z_{i(1)}) C_0 \Big) |0\rangle^{\otimes n}$$

Using properties of measurement and exponential (2) one can further rewrite computation as:

$C'M(a,P_2)\exp(i\phi P_1)|0\rangle^{\otimes n}$, where $C' = C_2 C_1 C_0$ One can transform any quantum computation to a sequence of exponentials and measurements of multiple-qubit Clifford operation and the Clifford gate in the end. The Clifford gate in the end does not need to be executed because information is not extracted from the quantum computer after executing it.

To perform an arbitrary computation under constraints described in Problem 3.1, it is sufficient to be able to perform measurements $M(a, P)$ and $\exp(i\phi P)$ for arbitrary Pauli matrices supported on certain qubits $V_{data} \subset V$. The size of subset $V_{data}$ determines a maximal number of qubits one can use for computation. It is sufficient to be able to perform a Clifford $C$ and $C^\dagger$ such that $CZ_r C^\dagger = P$ under constraints on two qubit operations described in Problem 3.1. Such Clifford operations can be constructed using multi-target Controlled-Z gates as described in Section 4. Table 1 and Table 2 show the programs for such a Clifford $C$ operation that uses multiple-target Controlled-Z gates. The program of Table 1 applies Controlled-Z gates on edges of the tree, and the program of Table 2 applies two qubit measurements. When using this construction for Clifford $C$, set $V_{data}$ corresponds to all leaves of the tree except the root.

In Section 5, a description is provided as to how to construct a tree with a high ratio of the number of leaves to the number of vertexes in 2D nearest neighbor architecture. Also considered is the case when fraction of the qubits in 2D nearest neighbor architecture is broken. It was found that when the fraction of broken is above 90%, one can still utilize good amount of qubits for computation.

```
# Input: V is the set of qubits, vertexes of a tree, E is the set of tree edges.
#|   |   |   Qubits with corresponding vertex degree > 1 are all in the plus state.
#|   |   |   P is a Pauli operator supported on tree leaves excluding the root.
# Effect: Clifford that maps Z on the root vertex to P is performed on tree leaves.
#|   |   |   |   The rest of the vertexes (the ones with
#|   |   |   |   degree > 1) are returned back to a plus state.
operation PauliMapper((V,E),P)
|   Let r be a root of (V,E)
|   Let V_targets be subset of leaves v such that P|_v ≠ I
|   Let V_excluded be leaves not in V_targets ∪ {r}
|   Let (V_1,E_1) be a sub-tree of (V,R) such that V_1 ∩ V_excluded = ∅
|   H_r
|   MultipleTargetControlledZ(V_1,E_1); see Table 6
|   H_r
|   Let v' be a vertex from V_targets
|   Let (V_path,E_path) be a sub-tree of (V,R) that only contains path from r to v'
|   H_v'
|   MultipleTargetControlledZ(V_path,E_path); see Table 6
|    H_v'
|   foreach v in V_targets
|    Apply single qubit Clifford that maps Pauli Z to P|_v
```

Table 1: Program for Pauli Mapper Using Controlled-Z Gates

## 4. LOW DEPTH MULTI-TARGET CONTROLLED-Z GATES

This section describes two ways of performing low-depth multi-target Controlled-Z gates. One is suitable for an architecture that has native Controlled-Z gates. Another one is for the architecture with two qubit operations restricted to only measurements of two qubit Pauli matrices. Notable for both is low depth circuit for cat state preparation and low depth circuit for fanout gate. In the following, qubits are considered to be vertexes of a tree and two qubit operations are allowed only

```
# Input: V is the set of qubits, vertexes of a tree, E is the set of tree edges.
#|   |   | Qubits with corresponding vertex degree > 1 are all in the plus state.
#|   |   | P is a Pauli operator supported on tree leaves excluding the root.
# Effect: Clifford that maps Z on the root vertex to P is performed on tree leaves.
#|   |   |   The rest of the vertexes (the ones with
#|   |   |   degree > 1) are returned back to a plus state.
operation PauliMapperMeasure((V,E),P)
  Let r be a root of (V,E)
  Let V_targets be subset of leaves $v$ such that P|$_v$ $\neq$ I
  Let $V_{excluded}$ be leaves not in V_targets $\cup \{r\}$
  Let (V$_1$,E$_1$) be a sub-tree of (V,R) such that V$_1 \cap V_{excluded} = \emptyset$
  Let (V$_2$,E$_2$) be the result of removing all leaves except the root from (V$_1$,E$_1$)
  Let L be a set of leaves of V$_2$
  foreach v in L
    Let (v,v') be an edge in V$_1$.
    Add (v,v') to (V$_2$,E$_2$)
  H$_r$
  MultipleTargetControlledZMeasure(V$_2$,E$_2$); see Table 7
  H$_r$
  foreach a in L
    Let (t,a) be an edge in V$_2$
    H$_t$
    foreach c in V such that (c,a) is an edge in V$_1$ but not in V$_2$
      ControlledZbyMeasurement(c,t,a) # See Proposition 4.5
    H$_t$
  Let v' be a vertex from V_targets
  Let (V_path,E_path) be a sub-tree of (V,R) that only contains path from r to v'
  H$_{v'}$
  MultipleTargetControlledZMeasure(V_path,E_path); see Table 7
  H$_{v'}$
  foreach v in V_targets
    Apply single qubit Clifford that maps Pauli Z to P|$_v$
```

Table 2: Example Program for Pauli Mapper Using Two Qubit Pauli Measurements

```
# Input: V is the set of qubits, vertexes of a tree, E is the set of tree edges
#|   |   |    All qubits are in the plus state.
#|   |   |    Tree (V,E) is edge colored, w is a qubit in V
# Effect: All qubits are in cat state
operation CatStatePrep(V,E,w)
|   foreach color c of the tree # number of colors is the largest vertex degree
|   |   foreach edge e = (u,v) of color c # body of this loop can be done in depth 1
|   |   |   Measure observable Z ⊗ Z on qubits u and v
|   |   |   Label edge e by the measurement outcome
|   |   |   Use label 0, when the outcome is +1 and label 1 otherwise
|   Assign vertex w label 0, assign other vertexes label 0 or 1
|   |   such that for every edge e=(u,v)
|   |   label(e) = label(u) ⊕ label(v). # this can be done using tree traversal
|   foreach vertex v # body of this loop can be done in depth 1
|   |   if label(v) = 1 then apply X to qubit v
```

Table 3: Program for cat state $(|0\rangle^{\otimes n} + |1\rangle^{\otimes n})/\sqrt{2}$ preparation in low depth

between qubits connected by an edge. Recall that when one needs to perform $Z \otimes Z$ measurements of qubits $a$ and $b$, it is equivalent to the following:

```
CNOTₐ,ᵦ # a is the control, b is the target
Measure Zᵦ
CNOTₐ,ᵦ
```

The next proposition shows that the circuit depth required to prepare cat state on a tree does not depend on the number of tree vertexes.

**Proposition 4.1** (Low depth cat state preparation). *Let (V, E) be a tree. Vertexes of the tree correspond to qubits. All the qubits are in plus state. One can only apply the following operations:*

- *measure observable $Z \otimes Z$ on qubits connected by an edge,*
- *apply Pauli X to any of the qubits except chosen in advance qubit w*

*Then the cat state on qubits corresponding to vertexes can be prepared using $|E| = |V| - 1$ of $Z \otimes Z$ measurements, in depth equal to the largest vertex degree. In addition, one requires at most $|V| - 1$ Pauli X operations performed all in parallel. The pseudo-code for cat state preparation is given in Table 3.*

*Proof.* First, it will be shown that the procedure on Table 3 indeed prepares the cat state. Recall that cat state

$$|\psi\rangle = (|0\rangle^{\otimes n} + |1\rangle^{\otimes n})/\sqrt{2}$$

on $n = |V|$ qubits can be uniquely described by the following constraints (up to the global phase):

$$\prod_{v \in V} X_v |\psi\rangle = |\psi\rangle, Z_u Z_v |\psi\rangle = |\psi\rangle, (u, v) \in E$$

Indeed, the above implies that $|\psi\rangle$ is stabilized by the following projector:

$$P = \frac{1}{2}\left(I + \prod_{v \in V} X_v\right) \prod_{(u,v) \in E} \frac{I + Z_u Z_v}{2}$$

Next, expand the above product into sum of Pauli matrices. Use $|E| = |V| - 1$ and that all non-identity Pauli matrices have trace zero to check that $\mathrm{Tr}(P) = 1$. Conclude that $P$ fixes one dimensional sub-space.

Initializing all qubits to $|+\rangle$ state ensures that their joint state is stabilized by $\Pi_{v \in V} X_v$. Measuring $Z_u Z_v$ for $(u, v) \in E$ ensures that the state is +1 or -1 eigenstate of $Z_u Z_v$. Note that because all constraints commute, adding a new one via measurement preserves all previous constraints. By the time all measurements were performed and the edges labeled, the state of the qubits $|\phi\rangle$ satisfies the following constraints:

$$\prod_{v \in V} X_v |\phi\rangle = |\phi\rangle, \, Z_u Z_v |\phi\rangle = (-1)^{\mathrm{label}(u,v)}|\phi\rangle, \, (u, v) \in E$$

It remains to fix the -1 signs. This can be done by applying single qubit Pauli $X$ operators to vertexes. One can label vertex with 0 if one does not apply $X$ to it, and with 1 if one does. This changes the signs in the following way:

$$Z_u Z_v \left(X_u^a X_v^b |\phi\rangle\right) = (-1)^{\mathrm{label}(u,v) \oplus a \oplus b}\left(X_u^a X_v^b |\phi\rangle\right),$$

$a = \mathrm{label}(u)$, $b = \mathrm{label}(v)$, $(u, v) \in E$

The label assignment can be found by one tree traversal, for example, using a depth first search. The label of the tree root can be chosen to be zero. The label of each vertex is computed based on the label of the parent and the label of the edge connecting the vertex and its parent.

Finally note that edges of each color do not share vertexes. For this reason, measurements on corresponding qubits can all be performed in parallel. This implies that the depth of the measurement part of the cat state preparation is equal to the chromatic number of the tree which is the largest vertex degree plus one. □

Given an $n$-qubit cat state it is sufficient to perform one two-qubit measurement to get a fanout gate

$$(\alpha|0\rangle + \beta|1\rangle) \otimes |+\rangle^{\otimes n-1} \mapsto \alpha|0\rangle^{\otimes n} + \beta|1\rangle^{\otimes n}$$

from one to $n+1$ qubits. The next proposition gives some intuition how one two qubit measurement can help perform a partially specified unitary acting on $n + 1$ qubits.

**Proposition 4.2** (Unitary operations via measurement). *Let $|\psi\rangle$ be a multiple qubit state and $P$ be a multiple qubit Pauli matrix that stabilizes $|\psi\rangle$ (e.g., $P|\psi\rangle = |\psi\rangle$). Let $Q$ be another multiple qubit Pauli matrix that anti-commutes with $P$. Then the probability of measuring +1 for observable $Q$ of $|\psi\rangle$ is 1/2. Moreover, if the measurement outcome is -1, then applying $P$ conditioned on the outcome -1 is equivalent to measuring +1. Under above conditions, one can always deterministically apply the following transformations to $|\psi\rangle$ via measurement:*

$$(3) \qquad\qquad |\psi\rangle \mapsto \frac{I + Q}{\sqrt{2}}|\psi\rangle = \exp\left(\frac{\pi}{4}QP\right)|\psi\rangle$$

*Proof.* First, the probability of measuring +1 is 1/2 is shown. One can show this by showing the probabilities of measuring +1 and —1 are equal. Recall that the probability of measuring $\pm 1$ is $\mathrm{Tr}\left(\frac{I \pm Q}{2}|\psi\rangle\langle\psi|\right)$. Next use that $P$ stabilizes $|\psi\rangle$ and anti-commutativity of $P$, $Q$ to check the following equalities:

$$\langle\psi|\frac{I + Q}{2}|\psi\rangle = \langle\psi|P\frac{I + Q}{2}P|\psi\rangle = \langle\psi|\frac{I + PQP}{2}|\psi\rangle =$$
$$= \langle\psi|\frac{I - Q}{2}|\psi\rangle$$

One can see that when the measurement outcome is +1, the state is transformed according to (3). Next check that this is again the case when the measurement outcome is -1 and apply correction *P*.

```
operation MeasurePlusOne(Q/P)
  ~ Assert: measuring P must always result in +1 ~
  r ← MeasureObservable(Q) # a is 0 if measured +1, and a is 1 if measured -1
  P^r # Applies P if measurement result is 1 and does nothing otherwise
```

Table 4: Program for `MeasurePlusOne`

If the measurement outcome was -1, one can apply correction *P* and the state becomes:

$$P\frac{I-Q}{\sqrt{2}}|\psi\rangle = \frac{I+Q}{\sqrt{2}}P|\psi\rangle = \frac{I+Q}{\sqrt{2}}|\psi\rangle$$

In the above, the anti-commutativity of *P*, *Q* was used and the fact that *P* stabilizes $|\psi\rangle$. Finally, one can note that $(I + Q)|\psi\rangle = (I + QP)|\psi\rangle$ and use the fact that for any matrix *A* that squares to minus identity $\exp(\phi A) = I\cos(\phi) + A\sin(\phi)$. □

It has been shown that under the conditions of Proposition 4.2 a measurement with classical feedback is equivalent to a unitary transformation. This is because *QP* is anti-hermitian matrix and $\exp\left(\frac{\pi}{4}QP\right)$ is a unitary. Note that unitary operation performed includes pauli *P*. Even if *Q* acts only on a couple qubits, the result of operation can be equivalent to a unitary on big number of qubits. This happens when contraint *P* involves large number of qubits.

The above discussion motivates the introduction of operation MeasurePlusOne(*Q/P*) (see Table 4). It performs operation given by Equation (3), given the state to which it is applied stabilized by *P*. In other words, operation MeasurePlusOne always projects the state onto +1 eigensubspace of *Q*. One can call *P* a constraint on the state.

Now it is shown how MeasurePlusOne can be used to perform fanout gate.

**Proposition 4.3** (Low depth fanout). *Let (V, E) be a tree. Vertexes of the tree correspond to qubits. All qubits except the root of the tree are in $|+\rangle$ state. One can only apply the following operations:*

- *measure observable $Z \otimes Z$ on qubits connected by an edge,*
- *apply Pauli X to any of the qubits.*

```
# Input: V is the set of qubits, vertexes of a tree, E is the set of tree edges.
#|   |   |   All qubits except the root of the tree are in a plus state
# Effect: Fanout gate is performed from the root to all qubits
operation Fanout1(V,E) # Concise version of the fanout operation used in the proof
|  Let (V',E') be a tree that is the result of removing the root from (V,E)
|  Let r be a root of (V,E) and (r,r') be an edge
|  CatStatePrep(V',E',r') # Prepare the cat state on the vertexes V', see Table 3
|  |  Let m be the result of measuring observable Z ⊗ Z between qubits r and r'
|  if m = -1 then
|  |  Apply Pauli X gates to all the qubits except the root of the tree

operation Fanout(V,E) # Depth optimized version of Fanout operation
|  foreach color c of the tree # number of colors is the largest vertex degree + 1
|  |  foreach edge e = (u,v) of color c # body of this loop can be done in depth 1
|  |  |  Measure observable Z ⊗ Z on qubits u and v
|  |  |  Label edge e by the measurement outcome
|  |  |  Use label 0, when the outcome is +1 and label 1 otherwise
|  Let r be a root of (V,E) and (r,r') be an edge
|  Assign vertex r' label 0, assign other vertexes label 0 or 1
|  |  such that for every edge e=(u,v)
|  |  label(e) = label(u) ⊕ label(v). # this can be done using tree traversal
|  if label(r,r') = 1 then
|  |  apply x ↦ x ⊕ 1 to labels of all vertexes
|  foreach vertex v except r # body of this loop can be done in depth 1
|  |  if label(v) = 1 then apply X to qubit v
```

Table 5: Program for fanout gate $(\alpha|0\rangle + \beta|1\rangle) \otimes |+\rangle^{\otimes n-1} \mapsto \alpha|0\rangle^{\otimes n} + \beta|1\rangle^{\otimes n}$

*The fanout gate from the root to all the qubits can be performed using |E| = |V| - 1 of Z ⊗ Z measurements, in depth equal to the largest vertex degree. In addition, one requires at most |V| - 1 Pauli X operations performed all in parallel. The pseudo-code for fanout gate is given in Table 5. Proof.* The correctness of operation Fanout1 in Table 5 is first shown. Next, it is shown that it is equivalent to operation Fanout described on the same table. The claim of the proposition regarding depth of $Z \otimes Z$ measurements follows from the fact that the number of colors in the edge coloring of the tree is equal to the maximal vertex degree plus one.

Let state of the root vertex be $\alpha|0\rangle + \beta|1\rangle$. According to Proposition 4.2, the last three lines of operation Fanout1 on Table 4 deterministically project on +1 eigenspace of $Z_rZ_{r'}$. This is because cat state is stabilized by the product of X over all non-root vertexes of the tree and this product anti-commutes with $Z_rZ_{r'}$. Therefore after last three lines of Fanout1 the state of all qubits becomes:

$$\frac{I + Z_1Z_2}{\sqrt{2}}(\alpha|0\rangle + \beta|1\rangle) \otimes \left(|0\rangle^{\otimes n} + |1\rangle^{\otimes n}\right)/\sqrt{2} = \alpha|0\rangle^{\otimes n} + \beta|1\rangle^{\otimes n}$$

This is because projector ($I + Z_1Z_2$)/2 selects computational basis states with first two bits equal:

$$(I + Z_1Z_2)|0\rangle|0\rangle^{\otimes n} = 2|0\rangle|0\rangle^{\otimes n}, (I + Z_1Z_2)|0\rangle|1\rangle^{\otimes n} = 0.$$

Next, a check is made that the operations Fanout and Fanout1 on Table 5 are equivalent. First, one can inline CatStatePrep. Next, one can observe that there is no X correction performed on vertex $r'$ before measuring $Z_r/Z_{r'}$. Therefore measurement $Z_rZ_{r'}$ can be performed together with all other measurements. Finally, X corrections applied in the end of CatStatePrep are combined with application of the X corrections in the end of Fanout1 operation. □

Next, a description is provided as to how to use the fanout gate to perform multiple target Controlled-Z. One can start with the case that is more suitable for the architecture with native Controlled-Z gates.

**Proposition 4.4** (Low depth multiple target Controlled-Z). *Let* (*V*, *E*) *be a tree. Vertexes of the tree correspond to qubits. Qubits that are not tree leaves are in a plus state. Measurements of observable Z $\otimes$ Z and Controlled-Z gates can only be applied to qubits connected by an edge. Programs given on Table 6 perform multiple target Controlled-Z gate with tree root being control and the rest of the leaves being targets. The rest of the tree vertices are returned back to plus state.*

*The depth of joint measurements is at most the largest vertex degree. The depth of Controlled-Z gates is at most the largest vertex degree. The total number of joint measurements and Controlled-Z operations applied equals to the total number of edges. The depth of X measurements is one.*

```
# Input: V is the set of qubits, vertexes of a tree, E is the set of tree edges.
#        Qubits with corresponding vertex degree >1 are all in the plus state.
# Effect: Multi-target controlled Z gate is performed with root of the tree
#being a control and the rest of the leaves being targets.
#The rest of the vertexes (the ones with degree > 1) are returned
#back to a plus state.
operation MultipleTargetControlledZ1(V,E) # Concise version used in a proof
  Let (V',E') be a tree that is the result of removing all leaves except the root
# from (V,E)
  Fanout(V',E') # Fanout gate from the root to the rest of the tree, see Table 4
  foreach leave v of (V,E) except the root
    Let (v,v') be an edge in E
    ControlledZ(v,v')
  Let r be the root of V and V'
  foreach vertex v of (V',E') except the root
    MeasurePlusOne(X_v/Z_vZ_r)


operation MultipleTargetControlledZ(V,E) # Depth optimized version
  Let (V',E') be a tree that is the result of removing all leaves except the root
  from (V,E)
  Fanout(V',E') # Fanout gate from the root to the rest of the tree, see Table 5
  foreach leave v of (V,E) except the root
    Let (v,v') be an edge in E
    ControlledZ(v,v')
  Let r be the root of V and V'
  foreach vertex v of (V',E') except the root # can be done in depth 1
    Measure X on qubit v, label v with zero if measured +1 and with 1 otherwise
  Label root with the parity of all leaves except the root
  foreach vertex v of (V',E')
    if label(v) is 1 then Apply Z to v
```

Table 5: Program for multi-target Controlled Z gate

*Proof.* It is first shown that program MultipleTargetControlledZ1 on Table 6 performs multiple target Controlled-Z gate and satisfies required postcondition. Next, it is shown that the program is equivalent to MultipleTargetControlledZ. Finally, the depth of the operations performed in MultipleTargetControlledZ are counted.

Recall that on computational basis states multiple-target Controlled-Z gate acts as following:

$$|c, t_1, \ldots, t_n\rangle = \prod_{k=1}^{n} \text{Controlled-Z}_{c,t_k} |c, t_1, \ldots, t_n\rangle = (-1)^{c(t_1 \oplus \ldots \oplus t_n)} |c, t_1, \ldots, t_n\rangle$$

Above the first qubit is control and the rest are targets. In this case, control and targets are leaves of the tree. One also has, say $m$, other qubits that are not leaves of the tree. Using fanout operation, the state transforms as:

$$|c, t_1, \ldots, t_n\rangle \otimes |+\rangle^{\otimes m} \mapsto_{\text{Fanout}} |c, t_1, \ldots, t_n\rangle \otimes |c\rangle^{\otimes m}$$

After the first foreach loop the state becomes:

$$(4) \qquad\qquad (-1)^{c(t_1 + \ldots + t_m)} |c, t_1, \ldots, t_n\rangle \otimes |c\rangle^{\otimes m}$$

This is because Controlled-Z gates are performed between each of the target qubits and some qubit that is not a leaf of the tree and is in state $|c\rangle$. Note that the above state (4) is +1 eigenstate of all $Z_r Z_v$ operators, where $r$ is a tree root and control qubit and $v$ are non-leaf qubits. For this reason, one can use MeasurePlusOne operations to set all non-leaf qubits back to plus state. It is important to note that setting one of the non-leaf qubits to plus state does not violate $Z_r Z_v$ constraints on other qubits and therefore this can be done in parallel.

To obtain MultipleTargetControlledZ program, one can inline all calls to MeasurePlusOne. Next one can observe that all measurements can be performed first and the correction can be performed afterwards. As shown below, one can also collect together all the corrections applied to the root vertex so the correction can be applied once.

To count the depth of $Z \otimes Z$ measurements, one can observe that they are all performed within Fanout operation and the larges vertex degree of $(V', E')$ is at most largest vertex degree of $(V, E)$. The depth of Controlled-Z operations performed is at most number of edges that share a vertex that is the largest degree of a vertex. □

The rest of this section is devoted to the architectures with two qubit measurements only. First recall how to perform Controlled-Z gate in this architectures using one extra qubit. It is convenient to use MeasurePlusOne($Q/P$) to concisely express this result. This result will also help one to get the insight needed for multiple target Controlled-Z.

**Proposition 4.5.** *Consider three qubits $a, b, c$, with qubit $a$ in $|+\rangle$ state, then the operation:*

```
operation ControlledZbyMeasurement(c,t,a)
    MeasurePlusOne (Z_a Z_t / X_a)
    H_a
    MeasurePlusOne(Z_a Z_c / Z_t X_a)
    MeasurePlusOne(X_a / Z_a Z_c)
```

*performs Controlled-Z gates between qubits $t, c$ and returns qubit $a$ to $|+\rangle$ state.*

*Proof.* Let one first check that all the MeasurePlusOne can be applied. The qubit $a$ is in $|+\rangle$, therefore the input state is stabilized by $X_a$. After the first step, as the result of the measurement, the overall state commutes with $Z_b Z_a$.

After applying the Hadamard to the second qubit, the state commutes with $H_a Z_b Z_a H_a^\dagger$ which is exactly $Z_t X_a$. After the third step, the state commutes with $Z_a Z_c$ as required on the step 4.

Now it will be shown that the Controlled-Z gate was indeed performed. It is sufficient to consider the case when all three qubits are in a tensor product state. Suppose the qubit $t$ is in state $\alpha_t|0\rangle + \beta_t|1\rangle$. After Step 1, the state of the qubits $t, a$ becomes:

$$\alpha_t|00\rangle + \beta_t|11\rangle$$

After Step 2 it is (up to normalization by $\sqrt{2}$ ):

$$\alpha_t|00\rangle + \alpha_t|01\rangle + \beta_t|10\rangle - \beta_t|11\rangle$$

Suppose qubit c is in state $\alpha_c|0\rangle + \beta_c|1\rangle$, then after Step 3, the state of all three qubits becomes:

$$\alpha_t\alpha_c|000\rangle + \alpha_t\beta_c|011\rangle + \beta_t\alpha_c|100\rangle - \beta_t\beta_c|111\rangle.$$

Finally, measuring $X_a$ transform the state into

$$\alpha_t\alpha_c|0+0\rangle + \alpha_t\beta_c|0+1\rangle + \beta_t\alpha_c|1+0\rangle - \beta_t\beta_c|1+1\rangle.$$

One can see that the state of the second qubit is $|+\rangle$ and the joint state of the first and the third qubits is

$$\alpha_t\alpha_c|00\rangle + \alpha_t\beta_c|01\rangle + \beta_t\alpha_c|10\rangle - \beta_t\beta_c|11\rangle = CZ_{tc}((\alpha_b|0\rangle + \beta_t|1\rangle) \otimes (\alpha_t|0\rangle + \beta_c|1\rangle)).$$

$\square$

Let one compare above program for Controlled-Z via measurement to version of MultipleTargetControlledZ operation applied to a tree with three vertexes *c, t, a* and edges (*c, a*)and (*a, t*):

```
MeasurePlusOne (ZaZt/Xa) # Fanout call corresponds to one operation
Controlled-Za,c
MeasurePlusOne(Xa/ZaZt)
```

The difference is that Hadamard followed by MeasurePlusOne($Z_aZ_t/Z_rX_a$) are in place of the call to Controlled-Z. It turns out that they perform a unitary similar to Controlled-Z.

**Proposition 4.6.** *The following two operations $H_2$; MeasurePlusOne($Z_2Z_3/Z_1X_2$) map computational basis states |aab⟩ to (-1)$^{ab}$|abb⟩ for a, b zero or one.*

*Proof.* Applying Hadamard gate transforms input state into:

$$|a\rangle \otimes \frac{|0\rangle + (-1)^a|1\rangle}{\sqrt{2}} \otimes b$$

The result of MeasurePlusOne($Z_3Z_2/Z_1X_2$) is:

$$\frac{I + Z_2Z_3}{2}|a\rangle \otimes (|0\rangle + (-1)^a|1\rangle) \otimes |b\rangle = (-1)^{ab}|abb\rangle.$$

$\square$

This is because ($I + Z_2Z_3$)/2 projects on the span of |00⟩, |11⟩.

Using this operation, one can construct multi-target Controlled-Z gate that uses only joint measurements and single qubit operations.

```
# Input: V is the set of qubits, vertexes of a tree, E is the set of tree edges.
#|   |   Qubits with corresponding vertex degree > 1 are all in the plus state.
#|   |   Two non-root leaves in (V,E) are never connected to the same vertex.
# Effect: Multi-target controlled Z gate is performed with root of the tree
#|   |   being a control and the rest of the leaves being targets.
#|   |   The rest of the vertexes (the ones with degree > 1) are returned back
#|   |   to a plus state.
operation MultipleTargetControlledZMeasure(V,E)
  Let r be a root of V
  Let (V',E') be a tree that is the result of removing all leaves r from (V,E)
  Fanout(V',E') # Fanout gate from the root to the rest of the tree, see Table 5
  foreach leave v of (V,E) except the root # this loop has measurement depth 1
    Let (v,v') be an edge in E
    H_{v'}
    MeasurePlusOne(Z_v Z_{v'} / Z_r X_{v'})


  # Two loops below can be performed in parallel in measurement depth 1
  foreach leaf v' of (V',E') except the root
    Let (v,v') be an edge in E
    MeasurePlusOne(X_{v'} / Z_v Z_{v'})

  foreach vertex v of (V',E') except the leaves
    MeasurePlusOne(X_v / Z_v Z_r)
```

Table 7: Program for Multi-Target Controlled Z Gate Via Measurement

**Proposition 4.7** (Low depth multiple target Controlled-Z by measurement). *Let* (*V*, *E*) *be a tree such that all it leaves except the root are connected to a vertex of degree two. In other words, non of these leaves connected to the same vertex. Vertexes correspond to qubits. All non-leaf qubits are in a plus state. The program MultipleTargetControlledZMeasure in Table 7 performs multiple target controlled Z gate with root being control and the rest of the leaves being targets. The measurement depth is at most the largest vertex degree plus two.*

*Proof.* Consider how MultipleTargetControlledZMeasure operation acts on inputs from computational basis. For each non-root leaf, in other words a target of control operations there is a unique vertex connected to it in a plus state. The state of such a pair in the beginning of the computation is $|t_1\rangle|+\rangle$. One can order qubits in the following way. First goes the control qubit, next pairs corresponding to each target qubit and the qubit connected to it, next the rest of the qubits. The state of all the qubits in the beginning of the computation is:

$$|c\rangle|t_1\rangle|+\rangle \ldots |t_n\rangle|+\rangle|+\rangle^{\otimes m}.$$

After applying the fanout operation, the state becomes:

$$|c\rangle|t_1\rangle|c\rangle \dots |t_n\rangle|c\rangle|c\rangle^{\otimes m}.$$

After the first foreach loop, according to Proposition 4.6, the state of the qubits becomes:

$$(-1)^{c(c_1+\dots+c_n)}|c\rangle|t_1\rangle|t_1\rangle \dots |t_n\rangle|t_n\rangle|c\rangle^{\otimes m}.$$

Now one can see that all the constraints in MeasurePlusOne operations in the last two foreach loops are satisfied by the state above. States $|t_k\rangle|t_k\rangle$ satisfy $Z_v Z_{v'}$ constraint appearing in the second foreach loop and state $|c\rangle|c\rangle$ satisfy constraints $Z_v Z_r$ appearing in the third foreach loop. After applying last two foreach loops the state of the qubits becomes

$$(-1)^{c(c_1+\dots+c_n)}|c\rangle|t_1\rangle|+\rangle \dots |t_n\rangle|+\rangle|+\rangle^{\otimes m}.$$

as required.

The last two foreach loops can be performed in parallel because they involve different qubits. Each of foreach loops has measurement depth one. Therefore the overall measurement depth is the measurement depth of fanout operation plus two. □

## 5. EMBEDDING A TREE INTO 2D GRID OF QUBITS

All data qubits should be connected to an interface qubit with a path of ancillas. Thus, only a fraction of all qubits can be data qubits, with the rest being used as ancillas for connectivity. Given a rectangular field of qubits with a nearest neighbor (each internal qubit has 4 neighbors) architecture, the most data qubits one can get is 2/3 of the total number of qubits. This is because an ancilla (barring the edges) can have at most 2 data qubits attached to it with the other two connections being used up to attach to two other ancillas.

An ideal field configuration would be a 3×N grid of qubits where the center row consists of ancillas and top and bottom rows are data qubits. This would achieve a perfect 2/3 ratio of data qubits to total qubits.

Assuming N×N grid of qubits, the best configuration to achieve the highest data qubits ratio is a comb, where the second column and qubits 2 to N in every third row of qubits, starting from row #2, are ancillas. The first row is reserved for interface qubits, and the rest are data qubits. For the calculations here, interface qubits to be data qubits are counted. In this configuration the ratio of data qubits to total qubits is $(2N-1)/3N$, or $2/3 - 1/3N$ which is very close to 2/3.

The physical qubits have some probability of failure. Some of the qubits in a perfect rectangular grid may be dead (unsuitable for use). This not only decreases the number of available qubits, but also breaks connectivity between the remaining ones. For example, a path of ancillas may have a dead qubit in it, severing part of the line and breaking connectivity of the corresponding data qubits to the interface qubit.

An algorithm to create an optimal layout of qubits given an irregular qubit graph is desirable. However, such an algorithm will require non-polynomial execution time, making it impractical. In accordance with the disclosed technology, a heuristic-based algorithm is provided that is close to optimal.

Given a starting layout of a comb described above, the algorithm determines pieces of the graph disconnected from the interface qubits and tries to reconnect them enabling as many data qubits as possible. Starting from the interface qubit, one can mark continuous horizontal ancilla line segments as powered if they are connected to the interface. For each powered segment, one can queue all possible vertical routes that can extend from it. The routes that start at the ends of the segments go into the high-priority queue, and the rest into normal priority queue.

Then, for each queued route (starting with high priority ones), one can determine if this route connects a previously unpowered ancilla segment, and if yes, accept the route, mark ancilla segment as powered, and add more potential routes starting from the newly powered segment to the queues. Each route that was accepted, converts two data qubits into ancillas. This continues until the queues are empty. Routes at the ends of segments are preferable, because they provide power to one or two additional data qubits (next to the dead ancilla), while routes spawning from mid-segments do not.

Each dead data qubit causes a loss of one data qubit in our ratio. Each dead ancilla causes two data qubits to be unpowered, and an ancilla segment to be detached. Reattaching the ancilla segment requires use of two data qubits and is likely to power back one of the disconnected qubits. Thus, each dead ancilla is likely to result in a loss of 3 data qubits.

6. EXEMPLARY MULTI-TARGET CNOT GATES

This section discloses further details for implementing multi-target CNOT gates in Majorana architectures as can be used in the disclosed technology.

6.1. **Introduction.** In a measurement based architecture such as a lattice of Majorana qubits, a CNOT gate can implemented by a sequence of four measurements using an ancilla qubit. Applying this circuit sequentially, one can implement a mutli-target CNOT gate with $m$ targets in time linear in m, in depth $4m$. In this section, a constant depth implementation for a multi-target CNOT gate based on single-qubit and two-qubit measurements is disclosed. The circuit has depth five in term of the number of levels of measurements (three two-qubit measurements and two single-qubit measurement). It requires one ancilla per target. This implementation is well suited for a grid of Majorana qubits.

The following circuits are made with single-qubit Pauli measurements and two-qubit Pauli measurements. Each measurement $M$ is a followed by a Clifford update $U(P)$ which means that the Clifford operation $P$ is a classically controlled gate that is applied only if the outcome of the measurement $M$ is 1. The update $U(P)$ is represented in the circuit as a box identical to the preceding measurement box for $M$ but it does not necessarily acts only on the support of $M$. We are particularly interested in the context of Majorana qubits. Then, single-qubit Clifford operations can be realized without any physical action on the qubits by a change of frame. In particular all Clifford updates are free. This is why the depth is considered as the number of levels of measurement.

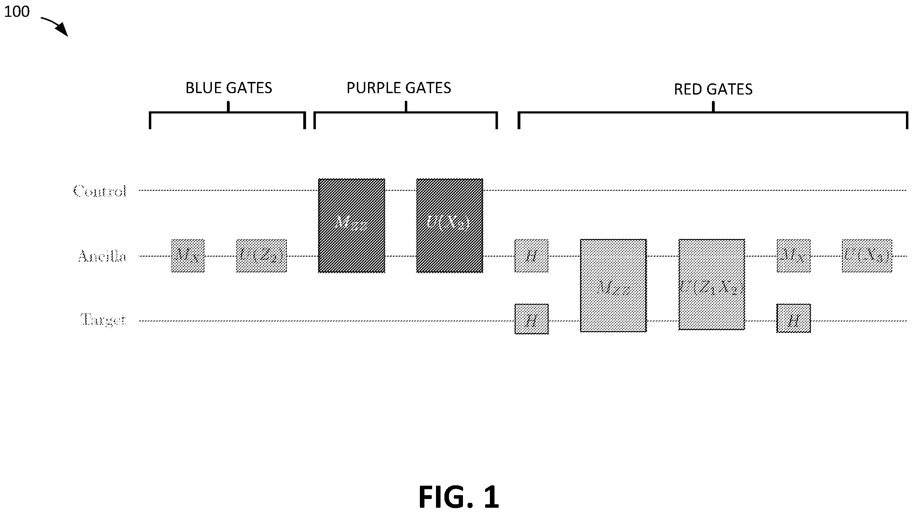

6.2. **CNOT gate by measurement.** In this subsection, recall the implementation of a CNOT gate using single-qubit and two-qubit measurements and an ancilla qubit. Figure 1 is a schematic block diagram 100 that represents the circuit realizing a CNOT gate between the top qubit and the bottom qubit. The middle qubit is an ancilla require for the CNOT gate. More specifically, the blue gates prepare the ancilla qubit, and the purple gates entangle it with the control qubit and the red gates act on the ancilla and the target qubits.

Denote by $|\psi\rangle = \alpha|0\rangle + \beta|1\rangle$ the contol qubit (qubit 1) and let $|\varphi\rangle = \alpha'|0\rangle + \beta|1\rangle$ be the target qubit (qubit 3). One can check that the circuit of Figure 1 realizes a CNOT gate. In order to simplify the calculation, one can show that without the $H$-conjugation on the last qubit, the circuit realizes the CZ-gate. Adding the two $H$ gate provides the CNOT gate.

- The first measurement $M_X$, followed by the update $U(Z_2)$ in case of outcome 1, prepares the ancilla qubit in the state $|+\rangle$. The combined state of qubits 1 and 2 is then

$$|\psi_0\rangle = \alpha|00\rangle + \alpha|01\rangle + \beta|10\rangle + \beta|11\rangle.$$

- Measuring $Z_1Z_2$ with outcome 0, projects the state of qubit 1 and 2 onto the state

$$|\psi_1\rangle = \alpha|00\rangle + \beta|11\rangle.$$

If the outcome 1 is obtained, one gets the state $\alpha|01\rangle + \beta|10\rangle$ that is mapped onto $|\psi_1\rangle$ by the update $U(X_2)$.
- The gate $H_2$ leads to $|\psi_2\rangle = \alpha|00\rangle + \alpha|01\rangle + \beta|10\rangle + (-1)\beta|11\rangle$ on the first two qubits, and (without considering $H_3$) the three-qubits state is then

$$|\psi_2\rangle = \alpha\alpha'|000\rangle - \alpha\alpha'|010\rangle + \beta\alpha'|100\rangle + (-1)\beta\alpha'|110\rangle$$
$$+ \alpha\beta'|001\rangle + \alpha\beta'|011\rangle + \beta\beta'|101\rangle + (-1)\beta\beta'|111\rangle$$

- If the outcome of $M_{Z_2Z_3}$ is 0, then the post-measurement state is

$$|\psi_3\rangle = \alpha\alpha'|000\rangle + \beta\alpha'|100\rangle + \alpha\beta'|011\rangle + (-1)\beta\beta'|111\rangle$$

If the outcome 1 is measured, the state after measurement is then

$$\alpha\alpha'|010\rangle + (-1)\beta\alpha'|110\rangle + \alpha\beta'|001\rangle + \beta\beta'|101\rangle$$

that one can map onto $|\psi_3\rangle$ by the update $U(Z_1X_2)$.
- Finally, get rid of the ancilla by measuring $X$. Assuming that the outcome is 0, one obtains the following state on qubit 1 and 3 after $M_X$.

$$|\psi_4\rangle = \alpha\alpha'|00\rangle + \beta\alpha'|10\rangle + \alpha\beta'|01\rangle + (-1)\beta\beta'|11\rangle$$

We recognize the control-Z gate applied to $|\psi\rangle$ and $|\phi\rangle$. If the outcome of $M_X$ is 1, one gets the state

$$\alpha\alpha'|00\rangle + \beta\alpha'|10\rangle + (-1)\alpha\beta'|01\rangle + \beta\beta'|11\rangle \cdot$$

A correction $U(Z_3)$ is required to map it onto $|\psi_4\rangle$. In the CNOT gate, this correction is conjugated by $H$ and becomes $U(X_3)$.

This proves that the circuit of Figure 1 realizes the CNOT gate.

6.3. **Multi-target CNOT gate.** A mutli-target CNOT gate applies a $X$ gate to a set of $m$ qubits $q_1, \dots, q_m$, controlled on the state of a unique control qubit $q_0$. Naively, it can be realized by a sequence of m CNOT gates, CNOT($q_0,q_i$) for $i = 1, \dots, m$. The depth of the multi-target CNOT gate is therefore at most linear in the number of targets. In this section, it is shown how to realize a multi-target gate in constant depth using one ancilla qubit for each target. While the same ancilla qubit can be reused for the sequential implementation of $m$ CNOT gates, $m$ ancillas are consumed for a constant depth implementation.

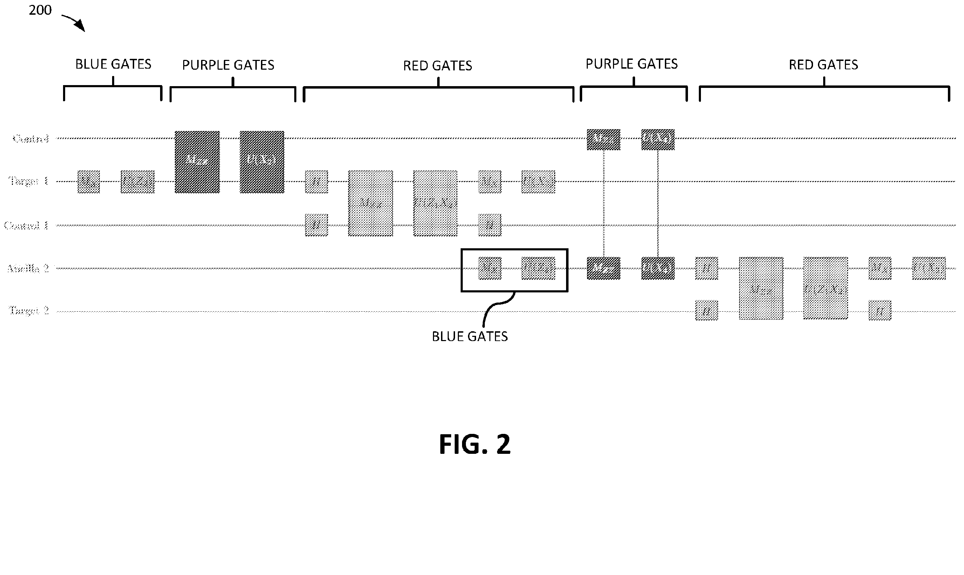

The transformation of the sequential implementation used to reduce the depth of the circuit to a constant is shown in Figures 2-4 in the case of a two-targets CNOT gate.

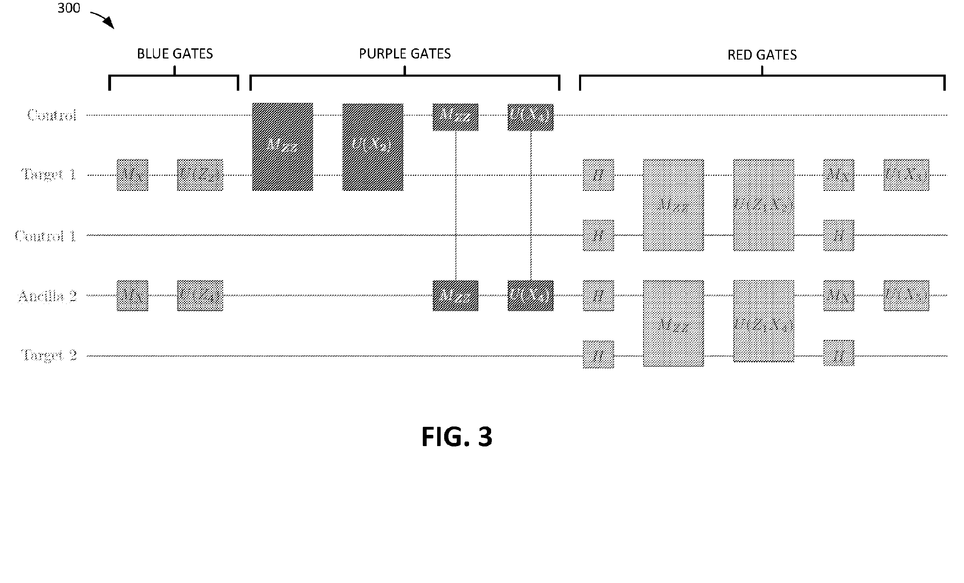

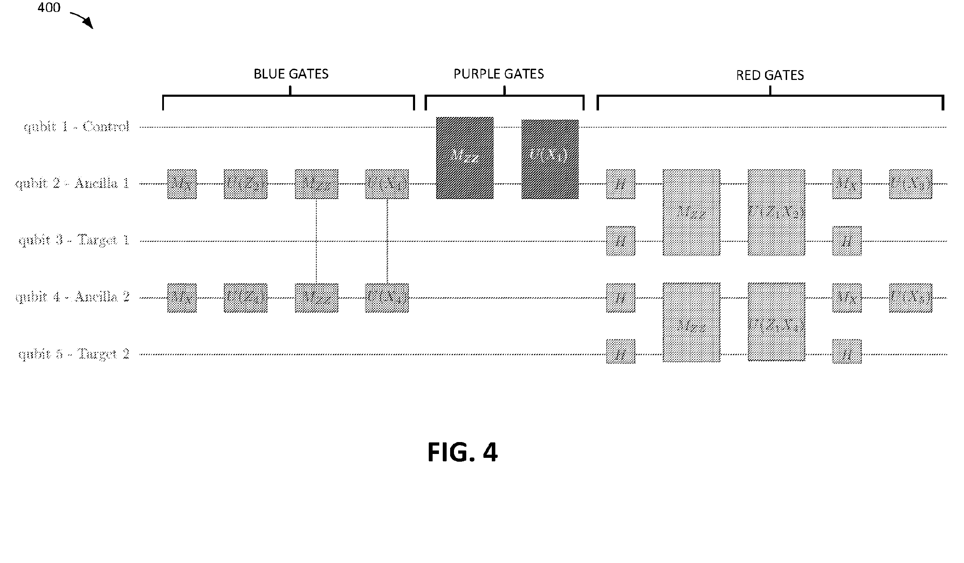

Figure 2 is a schematic block diagram 200 showing an example of providing a multi-target CNOT gate by measurement. In particular, block diagram 200 illustrates an example sequential application of the CNOT circuit. Figure 3 is a schematic block diagram 300 illustrating a modified version of block diagram 200 after moving the purple measurement $M_{Z_1Z_4}$ to the left to parallelize the final red block between the ancillas and the targets. Figure 4 is a schematic block diagram 400 illustrating further modifying the initial measurements to parallelize the purple block between the control qubit and the ancillas (The effect of this parallelization appears only when more than two targets are present).

As illustrated, this transformation can be performed in two steps. First, one moves the join measurement $M_{ZZ}$ between the control qubit and the ancillas to the past. This allows one to parallelize the final block of the circuit acting on the ancillas and the targets. In the second step, one can replace the $m$ measurements $M_{Z_{q_0}Z_{q_i}}$ involving the control qubit by a single measurement involving the control qubit $q_0$ and $m - 1$ measurements on the ancilla qubits that can be realized in depth two.

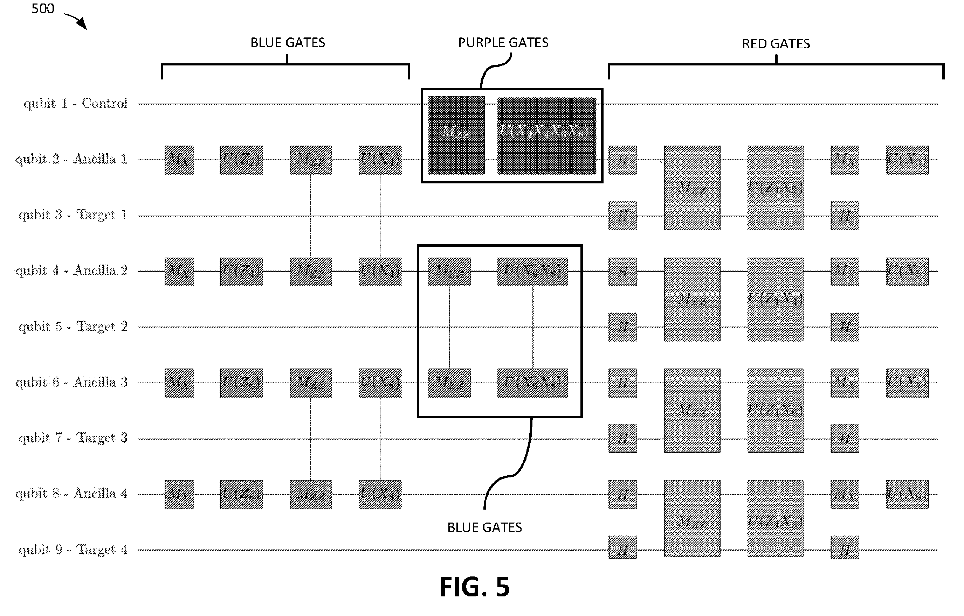

The general circuit, represented in schematic block diagram 500 of Figure 5 for four targets works as follows:

- (i) [Ancilla preparation (blue)] Prepare a $m$-qubits cat state $|0 \dots 0\rangle + |1 \dots 1\rangle$ over the $m$ ancilla qubits $a_1, \dots, a_m$ by measuring $Z_{a_1}Z_{a_2}, Z_{a_2}Z_{a_3}, \dots, Z_{a_{m-1}}Z_{a_m}$. This can be done in two layers of measurements (followed by updates).
- (ii) [Control block (purple)] Entangle the ancillas with the control qubit $q_0$ by measurement of $Z_{q_0}Z_{a_1}$. The update $U(X_{a_1}X_{a_2} \dots X_{a_m})$ is applied in case of non-zero outcome.
- (iii) [Target block (red)] Apply the target block of the standard CNOT by measurement in parallel to all the targets.

In order to check that this circuit realizes the multi-target CNOT as claimed, it suffices to check that the circuit maps any Pauli operators onto the same Pauli operator as the multi-target CNOT gate. Given a Pauli matrix $P$, denote by $P_C$ the Pauli operator acting as $P$ on the control qubit and acting trivially on all other qubits. Similarly $P_{a_i}$ acts on the $i$-th ancilla and $P_{T_i}$ on the $i$-th target. The multi-target CNOT gate is fully characterized by its action on Pauli operators as follows:

$$X_C \longmapsto X_C \prod_{i=1}^{m} X_{T_i}$$

$$Z_C \longmapsto Z_C$$

$$X_{T_i} \longmapsto X_{T_i}$$

$$Z_{T_i} \longmapsto Z_{T_i} Z_C$$

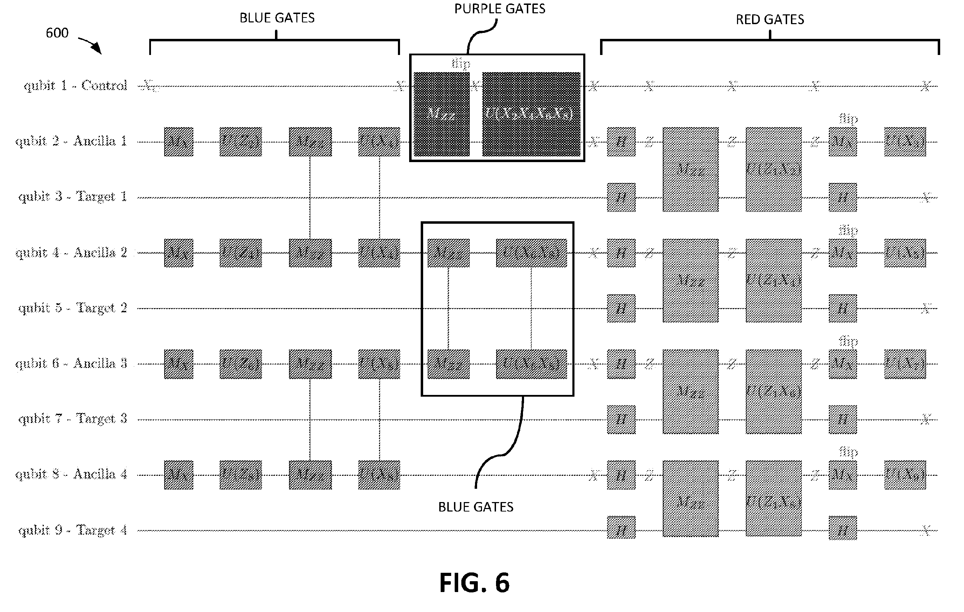

One can easily check that the circuit satisfies these identities by propagating these Pauli operators through the circuit. For instance, one can propagate the operation $X_C$ through the circuit in Figure 6. In particular, Figure 6 is a schematic block diagram 600 of a circuit that propagates the Pauli operator $X_C$ through the circuit. One can check that the circuit maps $X_C$ onto $X_C \prod_{i=1}^{m} X_{T_i}$ as expected

This proves that it implements the desired multi-target CNOT operation.

6.4. **Two-dimensional layout.** This multi-target CNOT gate can be implemented in a grid of Majorana qubits where all single-qubit measurement $M_X$, $M_Z$ are available, as well as two-qubit measurement $M_{P_1 P_2}$ of Pauli operators $P_1 P_2$ between neighbors qubits.

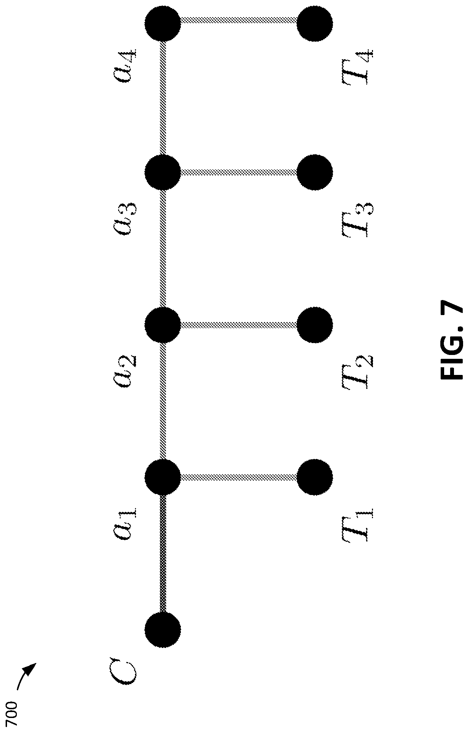

For instance, one can consider a line of $m$ ancilla qubits where the cat state is prepared, connected to the control qubit through one of its endpoints. Each ancilla can reach a target qubit placed directly below it. This allows for a local implementation of the mutli-target CNOT gate described in this note. Figure 7 is a block diagram 700 representing the planar layout for the multi-target CNOT gate of Figure 6.

## 7. Examples

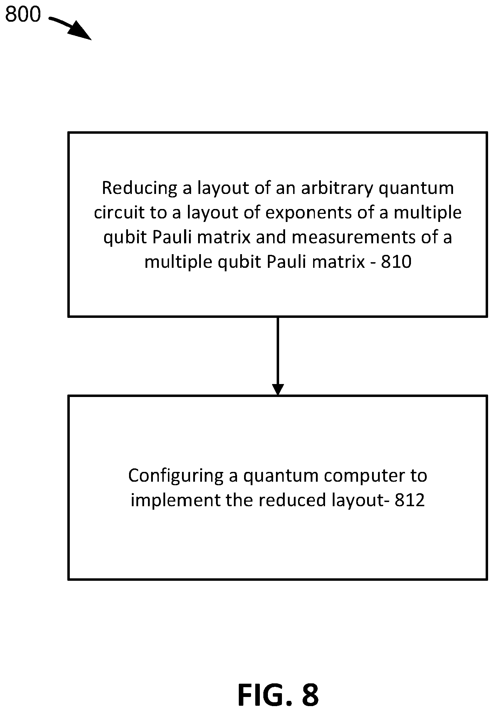

Figure 8 is an example method for performing a layout reduction technique for fault-tolerant quantum computing. The method is performed by one or more classical computing devices, at least some of which are in a configuration that can operate a quantum computer.

At 810, a layout of an arbitrary quantum circuit is reduced to a layout of exponents of a multiple qubit Pauli matrix and measurements of a multiple qubit Pauli matrix.

At 812, a quantum computer is configured to implement the reduced layout.

In particular implementations, qubits of the quantum computer comprise data qubits, interface qubits, and ancilla qubits. In further implementations, a graph of qubit connectivity satisfies a condition of providing an ancilla-path from one or more data qubits to the interface qubits.

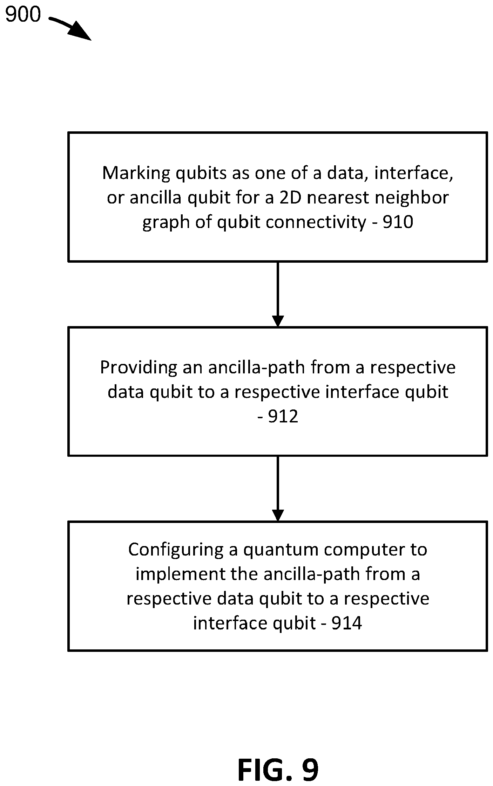

Figure 9 is an example method for performing a layout technique for fault-tolerant quantum computing. The method is performed by one or more classical computing devices, at least some of which are in a configuration that can operate a quantum computer.

At 910, qubits are marked as one of a data, interface, or ancilla qubit for a 2D nearest neighbor graph of qubit connectivity.

At 912, an ancilla-path is provided from a respective data qubit to a respective interface qubit. At 914, a quantum computer is configured to implement the ancilla-path from a respective data qubit to a respective interface qubit.

In certain implementations, the method accounts for and avoids any broken qubits and satisfies a condition of providing an ancilla-path from a data qubit to the interface qubits.

Any of the methods described above can be performed in a system, comprising a quantum computing device; and one or more classical-computing devices, at least some of the one or more classical computing devices being programmed to perform any of the disclosed methods.

Additionally, any of the methods described above can be implemented as one or more classical-computer-readable-media storing classical-computer-executable instructions, which when executed by a classical computer cause the classical computer to perform any of the disclosed methods.

Any of the methods described above can be implemented as one or more classical-computer-readable-media storing classical-computer-executable instructions, which when executed by a classical computer cause the classical computer to perform any of the disclosed methods.

## 8. EXAMPLE COMPUTING ENVIRONMENTS

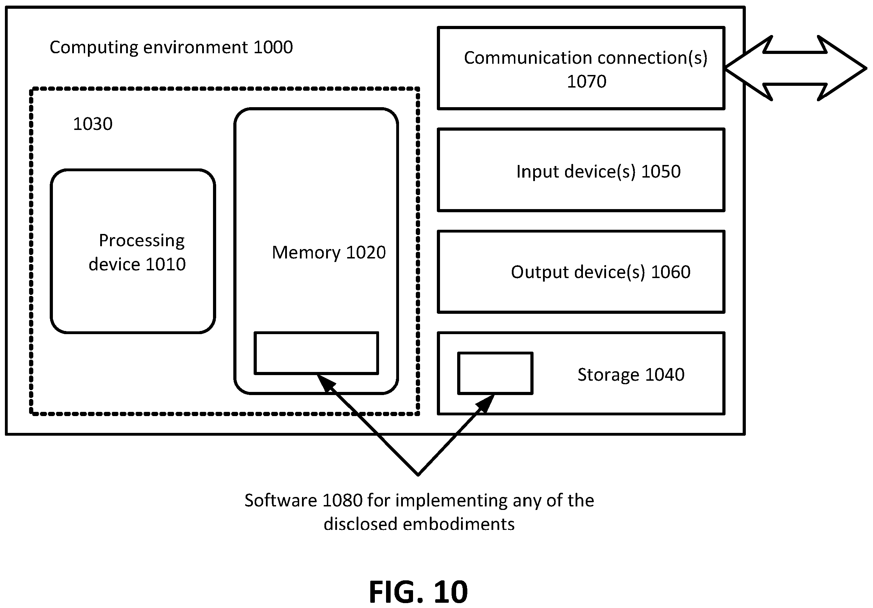

Figure 10 illustrates a generalized example of a suitable classical computing environment 1000. The computing environment 1000 is not intended to suggest any limitation as to the scope of use or functionality of the disclosed technology, as the techniques and tools described herein can be implemented in diverse general-purpose or special-purpose environments that have computing hardware.

With reference to Figure 10, the computing environment 1000 includes at least one processing device 1010 and memory 1020. In Figure 10, this most basic configuration 1030 is included within a dashed line. The processing device 1010 (e.g., a CPU or microprocessor) executes computer-executable instructions. In a multi-processing system, multiple processing devices execute computer-executable instructions to increase processing power. The memory 1020 may be volatile memory (e.g., registers, cache, RAM, DRAM, SRAM), non-volatile memory (e.g., ROM, EEPROM, flash memory), or some combination of the two. The memory 1020 stores software 1080 implementing tools for peforming any of the layout techniques for fault-tolerant quantum computers disclosed herein, using a classical computer and/or quantum computer. For example, the memory 1020 can store software for controlling a quantum circuit to implement an embodiment of the disclosed approximation technique. The memory 1020 can also store software 1080 for synthesizing, generating (or compiling), and/or controlling quantum circuits as described herein.

The computing environment can have additional features. For example, the computing environment 1000 includes storage 1040, one or more input devices 1050, one or more output devices 1060, and one or more communication connections 1070. An interconnection mechanism (not shown), such as a bus, controller, or network, interconnects the components of the computing environment 1000. Typically, operating system software (not shown) provides an operating environment for other software executing in the computing environment 1000, and coordinates activities of the components of the computing environment 1000.

The storage 1040 can be removable or non-removable, and includes one or more magnetic disks (e.g., hard drives), solid state drives (e.g., flash drives), magnetic tapes or cassettes, CD-ROMs, DVDs, or any other tangible non-volatile storage medium which can be used to store information and which can be accessed within the computing environment 1000. The storage 1040 can also store instructions for the software 1080 implementing tools for peforming any of the layout techniques for fault-tolerant quantum computers disclosed herein using a classical computer and/or quantum computer. For example, the memory 1020 can store software for controlling a quantum circuit to implement an embodiment of the disclosed layout techniques. The storage 1040 can also store instructions for the software 1080 for synthesizing, generating (or compiling), and/or controlling quantum circuits as described herein.

The input device(s) 1050 can be a touch input device such as a keyboard, touchscreen, mouse, pen, trackball, a voice input device, a scanning device, or another device that provides input to the computing environment 1000. The output device(s) 1060 can be a display device (e.g., a computer monitor, laptop display, smartphone display, tablet display, netbook display, or touchscreen), printer, speaker, or another device that provides output from the computing environment 1000.

The communication connection(s) 1070 enable communication over a communication medium to another computing entity. The communication medium conveys information such as computer-executable instructions or other data in a modulated data signal. A modulated data signal is a signal that has one or more of its characteristics set or changed in such a manner as to encode information in the signal. By way of example, and not limitation, communication media include wired or wireless techniques implemented with an electrical, optical, RF, infrared, acoustic, or other carrier.

As noted, the various methods, quantum circuit control techqniues, or compilation/synthesis techniques can be described in the general context of computer-readable instructions stored on one or more computer-readable media. Computer-readable media are any available media (e.g., memory or storage device) that can be accessed within or by a computing environment. Computer-readable media include tangible computer-readable memory or storage devices, such as memory 1020 and/or storage 1040, and do not include propagating carrier waves or signals per se (tangible computer-readable memory or storage devices do not include propagating carrier waves or signals per se).

The methods disclosed herein can also be described in the general context of computer-executable instructions (such as those included in program modules) being executed in a computing environment by a processor. Generally, program modules include routines, programs, libraries, objects, classes, components, data structures, and so on, that perform particular tasks or implement particular abstract data types. The functionality of the program modules may be combined or split between program modules as desired in various embodiments. Computer-executable instructions for program modules may be executed within a local or distributed computing environment.

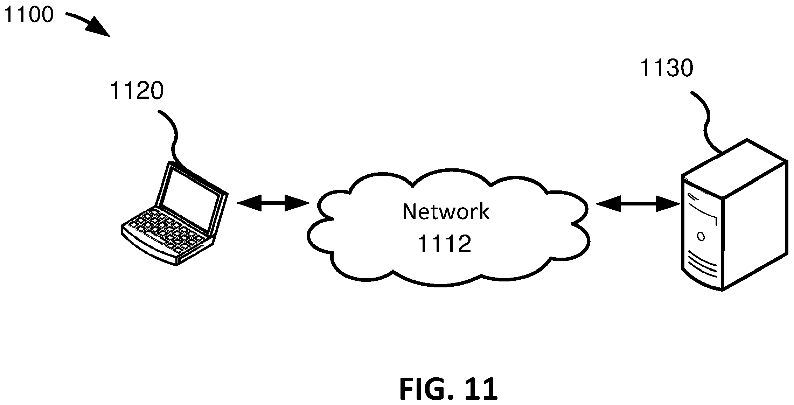

An example of a possible network topology 1100 (e.g., a client-server network) is depicted in Figure 11. Networked computing device 1120 can be, for example, a computer running a browser or other software connected to a network 1112. The computing device 1120 can have a computer architecture as shown in Figure 10 and discussed above. The computing device 1120 is not limited to a traditional personal computer but can comprise other computing hardware configured to connect to and communicate with a network 1112 (e.g., smart phones, laptop computers, tablet computers, or other mobile computing devices, servers, network devices, dedicated devices, and the like). Further, the computing device 1120 can comprise an FPGA or other programmable logic device. The computing device 1120 is configured to communicate with a computing device 1130 (e.g., a remote server, such as a server in a cloud computing environment) via a network 1112. The computing device 1120 is configured to transmit input data to the computing device 1130, and the computing device 1130 is configured to implement a quantum circuit control technique according to any of the disclosed embodiments and/or a circuit generation or compilation/synthesis methods for generating qunatum circuits for use with any of the techniques disclosed herein. The computing device 1130 can output results to the computing device 1120. Any of the data received from the computing device 1130 can be stored or displayed on the computing device 1120 (e.g., displayed as data on a graphical user interface or web page at the computing devices 1120). The illustrated network 1112 can be implemented as a Local Area Network (LAN) using wired networking (e.g., the Ethernet IEEE standard 802.3 or other appropriate standard) or wireless networking (e.g. one of the IEEE standards 802.11a, 802.11b, 802.11g, or 802.11n or other appropriate standard). Alternatively, at least part of the network 1112 can be the Internet or a similar public network and operate using an appropriate protocol (e.g., the HTTP protocol).

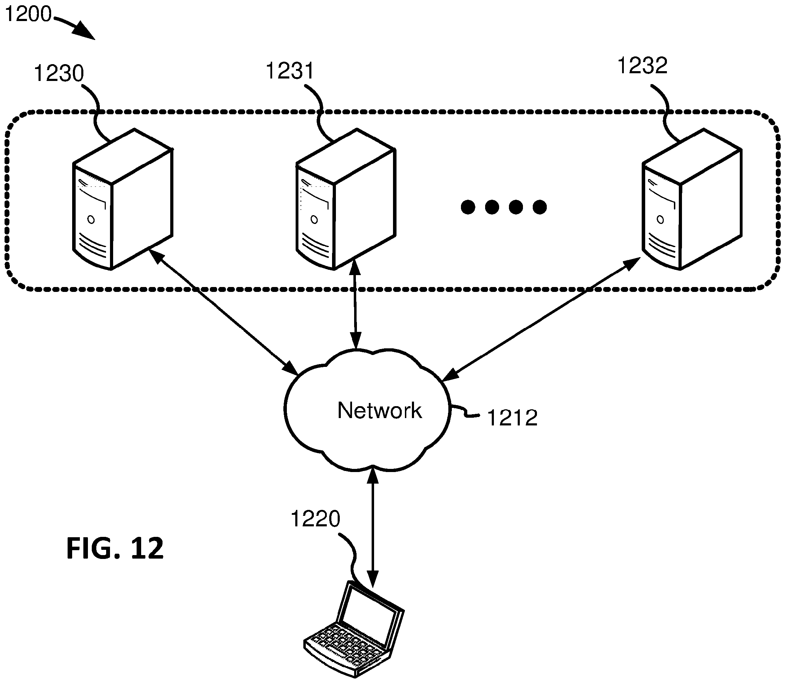

Another example of a possible network topology 1200 (e.g., a distributed computing environment) is depicted in Figure 12. Networked computing device 1220 can be, for example, a computer running a browser or other software connected to a network 1212. The computing device 1220 can have a computer architecture as shown in Figure 10 and discussed above. The computing device 1220 is configured to communicate with multiple computing devices 1230, 1231, 1232 (e.g., remote servers or other distributed computing devices, such as one or more servers in a cloud computing environment) via the network 1212. Each of the computing devices 1230, 1231, 1232 in the computing environment 1200 is used to perform at least a portion of a quantum circuit control technique according to any of the disclosed embodiments and/or a circuit generation or compilation/synthesis methods for generating quantum circuits for use with any of the techniques disclosed herein. In other words, the computing devices 1230, 1231, 1232 form a distributed computing environment in which the quantum circuit control and/or generation/compilation/synthesis processes are shared across multiple computing devices. The computing device 1220 is configured to transmit input data to the computing devices 1230, 1231, 1232, which are configured to distributively implement such as process, including performance of any of the disclosed methods or creation of any of the disclosed circuits, and to provide results to the computing device 1220. Any of the data received from the computing devices 1230, 1231, 1232 can be stored or displayed on the computing device 1220 (e.g., displayed as data on a graphical user interface or web page at the computing devices 1220). The illustrated network 1212 can be any of the networks discussed above with respect to Figure 11.

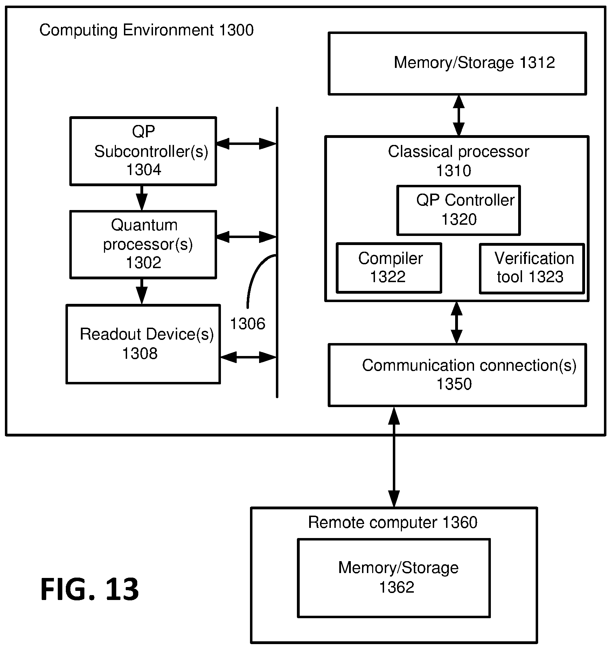

With reference to Figure 13, an exemplary system includes computing environment 1300. In computing environment 1300, a compiled quantum computer circuit description (including quantum circuits generated by any of the disclosed layout techniques) can be used to program (or configure) one or more quantum processing units such that the quantum processing unit(s) implement the circuit described by the quantum computer circuit description.

The environment 1300 includes one or more quantum processing units 1302 and one or more readout device(s) 1308. The quantum processing unit(s) execute quantum circuits that are precompiled and described by the quantum computer circuit description. The quantum processing unit(s) can be one or more of, but are not limited to: (a) a superconducting quantum computer; (b) an ion trap quantum computer; (c) a fault-tolerant architecture for quantum computing; and/or (d) a topological quantum architecture (e.g., a topological quantum computing device using Majorana zero modes). The precompiled quantum circuits, including any of the disclosed circuits, can be sent into (or otherwise applied to) the quantum processing unit(s) via control lines 1306 at the control of quantum processor controller 1320. The quantum processor controller (CaP controller) 1320 can operate in conjunction with a classical processor 1310 (e.g., having an architecture as described above with respect to Figure 10) to implement the desired quantum computing process. In the illustrated example, the CaP controller 1320 further implements the desired quantum computing process via one or more CaP subcontrollers 1304 that are specially adapted to control a corresponding one of the quantum processor(s) 1302. For instance, in one example, the quantum controller 1320 facilitates implementation of the compiled quantum circuit by sending instructions to one or more memories (e.g., lower-temperature memories), which then pass the instructions to low-temperature control unit(s) (e.g., CaP subcontroller(s) 1304) that transmit, for instance, pulse sequences representing the gates to the quantum processing unit(s) 1302 for implementation. In other examples, the CaP controller(s) 1320 and CaP subcontroller(s) 1304 operate to provide appropriate magnetic fields, encoded operations, or other such control signals to the quantum processor(s) to implement the operations of the compiled quantum computer circuit description. The quantum controller(s) can further interact with readout devices 1308 to help control and implement the desired quantum computing process (e.g., by reading or measuring out data results from the quantum processing units once available, etc.)

With reference to Figure 13, compilation is the process of translating a high-level description of a quantum algorithm into a quantum computer circuit description comprising a sequence of quantum operations or gates, which can include the circuits as disclosed herein. The compilation can be performed by a compiler 1322 using a classical processor 1310 (e.g., as shown in Figure 10) of the environment 1300 which loads the high-level description from memory or storage devices 1312 and stores the resulting quantum computer circuit description in the memory or storage devices 1312.

Compilation and/or verification can be performed remotely by a remote computer 1360 (e.g., a computer having a computing environment as described above with respect to Figure 10) which stores the resulting quantum computer circuit description in one or more memory or storage devices 1362 and transmits the quantum computer circuit description to the computing environment 1300 for implementation in the quantum processing unit(s) 1302. Still further, the remote computer 1300 can store the high-level description in the memory or storage devices 1362 and transmit the high-level description to the computing environment 1300 for compilation and use with the quantum processor(s). In any of these scenarios, results from the computation performed by the quantum processor(s) can be communicated to the remote computer after and/or during the computation process. Still further, the remote computer can communicate with the CaP controller(s) 1320 such that the quantum computing process (including any compilation, verification, and CaP control procedures) can be remotely controlled by the remote computer 1360. In general, the remote computer 1360 communicates with the CaP controller(s) 1320, compiler/synthesizer 1322, and/or verification tool 1323 via communication connections 1350.

The environment 1300 can be a cloud computing environment, which provides the quantum processing resources of the environment 1300 to one or more remote computers (such as remote computer 1360) over a suitable network (which can include the internet).

## Claims

1. A method performed by one or more classical computers (1310), comprising:

transforming a n-qubit quantum computation of the form $C_2 M(a, Z_{i(2)}) C_1 \exp(i\phi Z_{i(1)}) C_0 |0\rangle^{\otimes n}$, where $C_k$ are Clifford operators and the exponentials represent single qubit rotations,
to a sequence of exponentials and measurements of the form $M(a, P_2) \exp(i\phi P_1) |0\rangle^{\otimes n}$, in which $P_1$ and $P_2$ are multiple qubit Pauli operators, and $M(a, P_2) = (I + aP)/2$ denotes measurement of the multiple qubit Pauli operator $P_2$ with outcome $a = \pm 1$, where $I$ is the identity matrix, where

$$P_1 = C_0^\dagger Z_{i(1)} C_0 \,,$$

$$P_2 = (C_1 C_0)^\dagger M\big(a, Z_{i(2)}\big) C_1 C_0;$$

constructing a tree $(V, E)$ with root node $r \in V$, the tree describing a 2D grid of qubits, in which each vertex in $V$ describes a qubit in the 2D grid, and vertices describing nearest neighbor qubits in the 2D grid are connected by an edge in $E$; and
configuring a quantum computer (1308) comprising the 2D grid of qubits to implement the sequence of exponentials and measurements using:

one qubit measurements and one qubit Clifford unitaries,
either (A) controlled Z-gates or (B) two qubit measurements on nearest neighbor qubits described by vertices in $V$ connected by an edge in $E$, (A) or (B) being used to perform multi-target Controlled-Z gates, and each Clifford $C$ and $C^\dagger$ such that $CZ_r C^\dagger = P$ being constructed using multi-target Controlled-Z gates,
single qubit rotations that are only performed on the qubit described by the root node $r$.

2. A method of claim 1, wherein the qubits of the quantum computer (1308) comprise data qubits, interface qubits, and ancilla qubits, wherein every data qubit is connected to an interface qubit via a path of ancilla qubits.

3. A system (1300), comprising:

a quantum computer (1302); and
one or more classical-computing devices (1310), at least some of the one or more classical computing devices (1310) being programmed to perform the method of any one of claims 1-2.

4. One or more classical-computer-readable-media storing classical-computer-executable instructions, which when executed by a classical computer (1310) cause the classical computer (1310) to perform the method of any one of claims 1-2.

## Patentansprüche

1. Verfahren, das von einem oder mehreren klassischen Computern (1310) durchgeführt wird, umfassend:

Transformieren einer n-Qubit-Quantenberechnung der Form $C_2 M(a, Z_{i(2)}) C_1 \exp(i\oslash Z_{i(1)}) C_0 |0\rangle^{\otimes n}$, wobei $C_k$ Clifford-Operatoren sind und die Exponentiale Rotationen eines einzelnen Qubits darstellen, in eine Sequenz von Exponentialen und Messungen der Form $M(a,P_2)\exp(i\emptyset P_1)|0\rangle^{\otimes n}$, wobei $P_1$ und $P_2$ Pauli-Operatoren mit mehreren Qubits sind und $M(a, P_2) = (I + aP)/2$ die Messung des Pauli-Operators mit mehreren Qubits $P_2$ mit dem Ergebnis $a = \pm 1$ bezeichnet, wobei $I$ die Identitätsmatrix ist, wobei

$$P_1 = C_0^\dagger Z_{i(1)} C_0,$$

$$P_2 = (C_1 C_0)^\dagger M(a, Z_{i(2)}) C_1 C_0;$$

Konstruieren eines Baums $(V, E)$ mit Wurzelknoten $r \in V$, wobei der Baum ein 2D-Gitter von Qubits beschreibt, in dem jeder Vertex in $V$ ein Qubit in dem 2D-Gitter beschreibt und Vertices, die nächstgelegene Qubits in dem 2D-Gitter beschreiben, durch eine Kante in $E$ verbunden sind; und

Konfigurieren eines Quantencomputers (1308), umfassend das 2D-Gitter von Qubits, um die Sequenz von Exponentialen und Messungen unter Verwendung von Folgendem zu implementieren:

ein Qubit-Messungen und ein Qubit-Clifford-Einheiten,

entweder (A) kontrollierte Z-Gatter oder (B) zwei Qubit-Messungen an nächstgelegenen Qubits, die durch Vertices in $V$ beschrieben werden, die durch eine Kante in $E$ verbunden sind, wobei (A) oder (B) verwendet werden, um kontrollierte Z-Gatter mit mehreren Zielen durchzuführen, und wobei jeder Clifford $C$ und $C^\dagger$, sodass $CZ_r C^\dagger = P$ unter Verwendung von kontrollierten Z-Gattern mit mehreren Zielen konstruiert wird, einzelne Qubit-Rotationen, die nur an dem durch den Wurzelknoten $r$ beschriebenen Qubit durchgeführt werden.

2. Verfahren nach Anspruch 1, wobei die Qubits des Quantencomputers (1308) Daten-Qubits, Schnittstellen-Qubits und Ancilla-Qubits umfassen, wobei jedes Daten-Qubit mit einem Schnittstellen-Qubit über einen Pfad von Ancilla-Qubits verbunden ist.

3. System (1300), umfassend:

einen Quantencomputer (1302); und

eine oder mehrere klassische Rechenvorrichtungen (1310), wobei mindestens einige der einen oder mehreren klassischen Rechenvorrichtungen (1310) so programmiert sind, dass sie das Verfahren nach einem der Ansprüche 1-2 durchführen.

4. Ein oder mehrere klassische computerlesbare Medien, die klassische computerausführbare Anweisungen speichern, die, wenn sie von einem klassischen Computer (1310) ausgeführt werden, den klassischen Computer (1310) veranlassen, das Verfahren nach einem der Ansprüche 1-2 durchzuführen.

**Revendications**

1. Procédé exécuté par un ou plusieurs ordinateurs classiques (1310), comprenant :

la transformation d'un calcul de quantum de n bits quantiques de la forme $C_2 M(a, Z_{i(2)}) C_1 \exp(i\emptyset Z_{i(1)}) C_0 |0\rangle^{\otimes n}$, où les opérateurs $C_k$ représentent des opérateurs de Clifford et où les fonctions exponentielles représentent des rotations de bits quantiques simples, en une séquence de fonctions exponentielles et en mesures de la forme $M(a, P_2)\exp(i\emptyset P_1)|0\rangle^{\otimes n}$, dans laquelle $P_1$ et $P_2$ représentent des opérateurs de Pauli de bits quantiques multiples et où $M(a, P_2) = (I + aP)/2$ indique la mesure de l'opérateur de Pauli de bits quantiques multiples $P_2$ donnant pour résultat $a = \pm 1$, où $I$ représente la matrice d'identité, où

$$P_1 = C_0^\dagger Z_{i(1)} C_0,$$

$$P_2 = (C_1 C_0)^\dagger M(a, Z_{i(2)}) C_1 C_0 ;$$

la construction d'un arbre $(V, E)$ à noeud racine $r \in V$, l'arbre décrivant une grille 2D de bits quantiques, dans laquelle chaque sommet en *V* décrit un bit quantique de la grille 2D et où les sommets décrivant les bits quantiques voisins les plus proches de la grille 2D sont reliés par un bord en *E* ; et

la configuration d'un ordinateur quantique (1308) comprenant la grille 2D de bits quantiques pour implémenter la séquence de fonctions exponentielles et de mesures à l'aide des éléments suivants :

des mesures de bits quantiques et des unités de Clifford de bits quantiques,

soit (A) des portes à commande de Z, soit (B) deux mesures de bits quantiques sur les bits quantiques voisins les plus proches décrits par des sommets en *V* reliés par un bord en *E*, (A) ou (B) servant à effectuer des portes à cibles multiples et à commande de Z et chaque *C* et $C^{\dagger}$ de Clifford tel que $CZ_rC^{\dagger} = P$ est construit à l'aide de portes à cibles multiples et à commande de Z,

des rotations de bit quantique simple qui ne sont effectuées que sur le bit quantique décrit par le noeud racine *r*.

2. Procédé selon la revendication 1, dans lequel les bits quantiques de l'ordinateur quantique (1308) comprennent des bits quantiques de données, des bits quantiques d'interfaces et des bits quantiques auxiliaires, dans lequel chaque bit quantique de données est connecté à un bit quantique d'interface via un chemin de bits quantiques auxiliaires.

3. Système (1300) comprenant :

un ordinateur quantique (1302) ; et

un ou plusieurs dispositifs informatiques classiques (1310), au moins une partie du ou des dispositifs informatiques classiques (1310) étant programmée pour effectuer le procédé selon l'une quelconque des revendications 1 ou 2.

4. Un ou plusieurs supports à lecture informatique classique stockant des instructions à exécution informatique classique qui, quand elles sont exécutées par un ordinateur classique (1310), amènent l'ordinateur classique (1310) à effectuer le procédé selon l'une quelconque des revendications 1 ou 2.

**FIG. 1**

FIG. 2

**FIG. 3**

FIG. 4

EP 3 788 564 B1

FIG. 5

**FIG. 6**

**FIG. 7**

800

Reducing a layout of an arbitrary quantum circuit to a layout of exponents of a multiple qubit Pauli matrix and measurements of a multiple qubit Pauli matrix - 810

Configuring a quantum computer to implement the reduced layout- 812

**FIG. 8**

900

Marking qubits as one of a data, interface, or ancilla qubit for a 2D nearest neighbor graph of qubit connectivity - 910

Providing an ancilla-path from a respective data qubit to a respective interface qubit - 912

Configuring a quantum computer to implement the ancilla-path from a respective data qubit to a respective interface qubit - 914

FIG. 9

EP 3 788 564 B1

Computing environment 1000

Communication connection(s) 1070

Input device(s) 1050

Output device(s) 1060

Storage 1040

1030

Memory 1020

Processing device 1010

Software 1080 for implementing any of the disclosed embodiments

FIG. 10

35

**FIG. 11**

EP 3 788 564 B1

**FIG. 12**

Computing Environment 1300

Memory/Storage 1312

QP Subcontroller(s) 1304

Quantum processor(s) 1302

Readout Device(s) 1308

1306

Classical processor 1310

QP Controller 1320

Compiler 1322

Verification tool 1323

Communication connection(s) 1350

Remote computer 1360

Memory/Storage 1362

**FIG. 13**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 62681540

### Non-patent literature cited in the description

- Fault-Tolerant Quantum Computing in the Pauli or Clifford Frame with Slow Error Diagnostics. **CHRISTOPHER CHAMBERLAND et al.** ARXIV.ORG. CORNELL UNIVERSITY LIBRARY, 21 April 2017
- Local and Distributed Quantum Computation. **RODNEY VAN METER et al.** ARXIV.ORG. CORNELL UNIVERSITY LIBRARY, 23 May 2016
- **ALEXANDRU PALER et al.** Fault-tolerant, high-level quantum circuits: form, compilation and description. *QUANTUM SCIENCE AND TECHNOLOGY,* 12 April 2017, vol. 2 (2), 1-18